# EUROPEAN PATENT APPLICATION

(11) **EP 2 610 017 A1**
(43) Date of publication of application: **03.07.2013**
(21) Application number: 12196408.4
(22) Date of filing: 11.12.2012
(51) Int. Cl.: B08B 3/12

(54) **Ultrasonic cleaning method**

(30) Priority: 26.12.2011 JP 2011283338
(71) Applicant: Siltronic AG, 81737 München (DE)
(72) Inventor: Haibara, Teruo, Hikari, Yamaguchi 743-0011 (JP); Tanabe, Etsuko, Hikari, Yamaguchi 743-0031 (JP); Mori, Yoshihiro, Shunan, Yamaguchi 745-0651 (JP); Uchibe, Masashi, Hikari, Yamaguchi 743-0072 (JP)
(74) Representative: Baar, Christian

(57) **Abstract**

Ultrasonic cleaning method for irradiating ultrasonic waves to a solution having gas dissolved therein for cleaning an object to be cleaned in the solution. The method includes the following steps. Ultrasonic waves are irradiated to the solution having the first dissolved gas concentration. In the state where ultrasonic waves are irradiated to the solution, the dissolved gas concentration in the solution is changed from the first dissolved gas concentration to the second dissolved gas concentration lower than the first dissolved gas concentration. Sonoluminescence occurs by irradiating ultrasonic waves to the solution while the dissolved gas concentration in the solution is changed from the first dissolved gas concentration to the second dissolved gas concentration.

## Description

### Technical Field

The present invention relates to an ultrasonic cleaning method, and particularly to an ultrasonic cleaning method for irradiating ultrasonic waves to a solution having gas dissolved therein for cleaning an object to be cleaned in the solution.

### Background Art

Conventionally, in the process of manufacturing a substrate such as a silicon wafer, the process of cleaning a substrate in the manner of dip processing, single wafer processing and the like has been carried out for the purpose of removing, from this substrate, organic substances, metal contaminations, particles, native oxide film and the like which result in defects in a semiconductor device.

In the process of cleaning a substrate, various types of cleaning methods are used depending on the purpose. Particularly, in the case where foreign substances such as particles are removed by the dip-type cleaning method, such a method is used that a substrate is dipped in the cleaning solution contained in the cleaning bath which is then irradiated with ultrasonic waves having a frequency about 1 MHz that is referred to as megasonic. It is generally considered that the ultrasonic waves having a frequency about 1 MHz allow improvement in the cleaning effect for microparticles of a submicron size on the surface of the substrate while allowing reduction in damage to the substrate.

It is known in this case that the concentration of the dissolved gas in the cleaning solution exerts an influence upon the removal efficiency of foreign substances such as particles. For example, it is known that, when megasonic is irradiated to ultrapure water used as a cleaning solution to thereby remove particles from the substrate, the particle removal efficiency from the substrate is influenced by the dissolved nitrogen concentration in the cleaning solution. More specifically, when the dissolved gas concentration in the cleaning solution falls within a prescribed range, the particle removal efficiency from the substrate is relatively high (Japanese Patent Laying-Open Nos. JP10-109072 and JP2007-250726). Therefore, the dissolved gas concentration such as a dissolved nitrogen concentration in the cleaning solution is monitored in the cleaning process to control the dissolved gas concentration in the cleaning solution to fall within a fixed range, which theoretically allows the particles to be effectively removed.

On the other hand, it has been reported that there is a certain relationship between the weak luminescence behavior occurring when ultrasonic waves are irradiated to the cleaning solution (sonoluminescence) and the particle removal behavior of the substrate ("Behaviour of a Well Designed Megasonic Cleaning System", Solid State Phenomena, Vols. 103 to 104, (2005) pp. 155 to 158; "Megasonics: a cavitation driven process", Solid State Phenomena, Vols. 103 to 104, (2005), pp. 159 to 162.).

### Problems to be Solved by the Invention

In the inventor's study of conventional ultrasonic cleaning for a substrate, there were cases where both of high and low particle removal efficiency was achieved even in the same dissolved gas concentration and under the same conditions for irradiation of ultrasonic waves. Furthermore, even if high particle removal efficiency could be achieved, it was difficult to continuously maintain such a state.

The present invention has been made in the light of the above-described problems, and an object of the present invention is to provide an ultrasonic cleaning method that allows a high particle removal efficiency to be achieved with stability.

### Means for Solving the Problems

As a result of earnest study about the relationship between the dissolved gas concentration and sonoluminescence, the inventors have found that there are cases where sonoluminescence occurs and where sonoluminescence does not occur even in the same dissolved gas concentration and under the same condition for irradiation of ultrasonic waves. The inventors also found that there is a relationship between the particle removal efficiency and occurrence of sonoluminescence, and the particle removal efficiency is high when sonoluminescence occurs while the particle removal efficiency is low when sonoluminescence does not occur. Furthermore, the inventors also have found that irradiation of ultrasonic waves is started in a high dissolved gas concentration at first, and then, the dissolved gas concentration is lowered in the state where irradiation of ultrasonic waves is continued, which leads to a particle removal efficiency higher than that in the case where ultrasonic cleaning is carried out in a fixed dissolved gas concentration from the beginning, even when the final dissolved gas concentrations are the same.

Then, an explanation will be hereinafter made with regard to the mechanism in which the particle removal efficiency is increased in the case where irradiation of ultrasonic waves is started in a high dissolved gas concentration at first, and then, the dissolved gas concentration is lowered in the state where irradiation of ultrasonic waves is continued.

First, when ultrasonic waves are irradiated to ultrapure water, dissolved gas is precipitated by cavitation and fine bubbles generate, which cause ultrasonic vibration, bursts and the like to occur, with the result that the particles on the wafer surface are removed. In the state where the dissolved gas concentration is extremely low (the state close to degassed water), generated fine bubbles are few due to a decrease in dissolved gas, and therefore, the particle removal capability is decreased. When the dissolved gas concentration is too high, bubbles are readily generated, which leads to generation not only of fine bubbles but also of a great amount of large bubbles. Large bubbles hardly cause vibrations and bursts effective in cleaning. In addition, large bubbles themselves prevent propagation of ultrasonic waves. Consequently, the particle removal capability is deteriorated. For the reasons as described above, it is considered that the particle removal capability is improved on the conditions under which a great amount of fine bubbles effective in cleaning are generated, and also that its optimum dissolved concentration lies in the intermediate concentration range.

However, it has been found in the present study that, even in the same dissolved gas concentration in the intermediate concentration range, there exist two types of states where sonoluminescence occurs and where sonoluminescence does not occur. When observed specifically, it has been found that fine bubbles are not generated in the state where sonoluminescence does not occur. It has also been found that a trigger for generating these fine bubbles is required in order to cause sonoluminescence to occur.

In the state where the dissolved gas concentration is high, bubbles are readily generated by irradiation of ultrasonic waves. Occurrence of sonoluminescence is induced by starting irradiation of ultrasonic waves in the state where the dissolved gas concentration is high. Then, when the dissolved gas concentration is lowered in the state where the dissolved gas concentration remains high, it becomes possible to achieve the target dissolved gas concentration in the state where the fine bubbles are kept generated. Thus, it is considered that it becomes possible to continuously generate fine bubbles with stability in the range of the target dissolved gas concentration with a high cleaning capability, with the result that a high particle removal efficiency is achieved.

The ultrasonic cleaning method according to the present invention is to irradiate ultrasonic waves to a solution having gas dissolved therein for cleaning an object to be cleaned in the solution. The method includes the following steps. Ultrasonic waves are irradiated to the solution having a first dissolved gas concentration. In a state where ultrasonic waves are being applied to the solution, a dissolved gas concentration in the solution is changed from the first dissolved gas concentration to a second dissolved gas concentration lower than the first dissolved gas concentration. Sonoluminescence continuously occurs by continuously irradiating ultrasonic waves to the solution while the dissolved gas concentration in the solution is changed from the first dissolved gas concentration to the second dissolved gas concentration.

According to the ultrasonic cleaning method in accordance with the present invention, after starting irradiation of ultrasonic waves in a high dissolved gas concentration at first, the dissolved gas concentration is decreased in the state where irradiation of ultrasonic waves is continued. This allows achievement of a particle removal efficiency that is higher than that in the case where ultrasonic cleaning is carried out in a constant dissolved gas concentration from the beginning. Furthermore, according to the ultrasonic cleaning method in accordance with the present invention, since it is possible to cause a sonoluminescence state to occur in a relatively wide dissolved gas concentration range, a high particle removal efficiency can be achieved with stability.

In the above-described ultrasonic cleaning method, irradiation of ultrasonic waves may be started at a point of time when the dissolved gas concentration reaches the first dissolved gas concentration.

In the above-described ultrasonic cleaning method, ultrasonic waves may be started to be irradiated to the solution having a third dissolved gas concentration lower than the first dissolved gas concentration.

The above-described ultrasonic cleaning method further includes the step of changing the dissolved gas concentration in the solution from the third dissolved gas concentration to the first dissolved gas concentration in a state where ultrasonic waves are being irradiated to the solution.

In the above-described ultrasonic cleaning method, preferably, the step of changing the dissolved gas concentration from the third dissolved gas concentration to the first dissolved gas concentration is performed by adding a solution having the dissolved gas concentration higher than the third dissolved gas concentration to a cleaning bath housing the object to be cleaned.

In the above-described ultrasonic cleaning method, preferably, the gas is nitrogen and the second dissolved gas concentration is not less than 4 ppm and not more than 10 ppm.

### Effects of the Invention

The present invention can provide an ultrasonic cleaning method allowing a high particle removal efficiency to be achieved with stability.

### Brief Description of the Drawings

Fig. 1 is a schematic diagram showing an ultrasonic cleaning apparatus according to the present first embodiment.
Fig. 2 is a schematic diagram showing an ultrasonic cleaning apparatus according to the present second embodiment.
Fig. 3 is an example diagram of an apparatus configuration for observing sonoluminescence.
Fig. 4 is a flow diagram showing an ultrasonic cleaning method according to the present first embodiment.
Fig. 5 is a diagram showing the relationship between the dissolved gas concentration and the time in accordance with the ultrasonic cleaning method according to the present first embodiment.
Fig. 6 is a flow diagram showing an ultrasonic cleaning method according to the present second embodiment.
Fig. 7 is a diagram showing the relationship between the dissolved gas concentration and the time in accordance with the ultrasonic cleaning method according to the present second embodiment.
Fig. 8 is a flow diagram showing an ultrasonic cleaning method according to Example 1 of the present invention.
Fig. 9 is a diagram showing the relationship between the dissolved gas concentration and the time in accordance with the ultrasonic cleaning method according to Example 1 of the present invention.
Fig. 10 is a flow diagram showing an ultrasonic cleaning method according to Example 2 of the present invention.
Fig. 11 is a diagram showing the relationship between the dissolved gas concentration and the time in accordance with the ultrasonic cleaning method according to Example 2 of the present invention.
Fig. 12 is a flow diagram showing an ultrasonic cleaning method according to a comparative example.
Fig. 13 is a diagram showing the relationship between the dissolved gas concentration and the time in accordance with the ultrasonic cleaning method according to the comparative example.
Fig. 14 (a) is a diagram showing the relationship between the dissolved nitrogen concentration and the luminescent state according to the method in the comparative example.
Fig. 14 (b) is a diagram showing the relationship between the dissolved nitrogen concentration and the luminescent state according to the method in an example of the present invention.

### Description of the Reference Characters

10: supply means
11: first supply valve
12: second supply valve
13: third supply valve
20: cleaning bath
21: coupling bath
22: holding unit
23: solution introduction pipe
30: irradiation means
40: monitoring means
41: extraction pipe
42: pump
43: dissolved nitrogen concentration meter
50: dark room
60: luminescence detection device
61: image processing device
1, 100, 200: ultrasonic cleaning apparatus
W: wafer

### Best Modes for Carrying Out the Invention

The embodiments according to the present invention will be hereinafter described with reference to the drawings, in which the same or corresponding components are designated by the same reference characters, and description thereof will not be repeated.

### First Embodiment

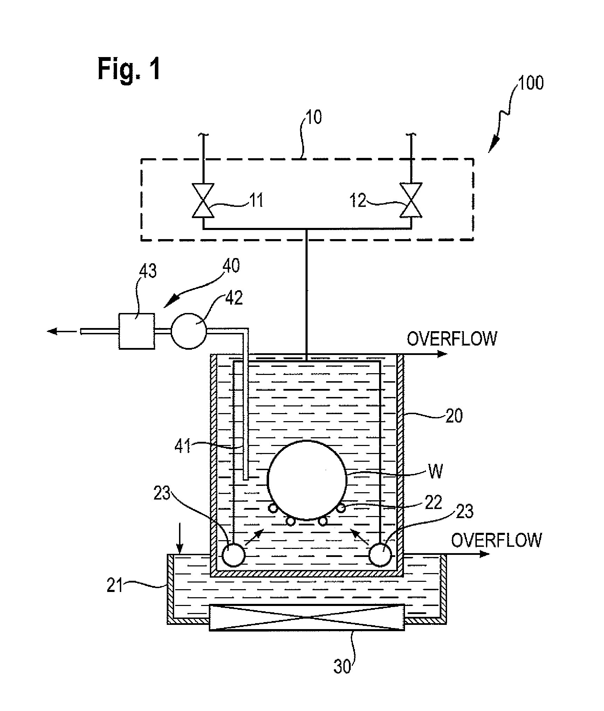

As shown in Fig. 1, an ultrasonic cleaning apparatus 100 to which the ultrasonic cleaning method according to the present first embodiment is applied includes a cleaning bath 20 containing a cleaning solution such as ultrapure water, supply means 10 for supplying the cleaning solution to this cleaning bath 20, a coupling bath 21 housing cleaning bath 20, irradiation means 30 disposed at the bottom of coupling bath 21 for irradiating ultrasonic waves, and monitoring means 40 for monitoring the dissolved nitrogen concentration in the cleaning solution supplied into cleaning bath 20. Supply means 10 has a first supply valve 11 for supplying ultrapure water having nitrogen gas dissolved therein to cleaning bath 20, and a second supply valve 12 for supplying degassed ultrapure water to cleaning bath 20.

First supply valve 11 is connected to a first tank which is not shown. The ultrapure water having nitrogen gas dissolved therein is stored in the first tank. Second supply valve 12 is connected to a degasifier which is not shown. The degasifier is supplied with ultrapure water and capable of removing the dissolved gas in the ultrapure water through a degassing film. The ultrapure water having nitrogen gas dissolved therein and the degassed ultrapure water are mixed by a pipe formed by combining pipes connected to first supply valve 11 and second supply valve 12 in the downstream of first supply valve 11 and second supply valve 12. In addition, a mixing bath (not shown) may be disposed in the downstream of first supply valve 11 and second supply valve 12. In this case, the ultrapure water having nitrogen gas dissolved therein and the degassed ultrapure water can be completely mixed in this mixing bath.

Then, the mixed ultrapure water is supplied to a solution introduction pipe 23 through a pipe that is disposed within cleaning bath 20 and connected to the downstream of the above-described first supply valve 11 and second supply valve 12. Solution introduction pipe 23 is disposed in the vicinity of the outer peripheral end of the bottom of cleaning bath 20. In addition, the valve position of each of first supply valve 11 and second supply valve 12 is adjusted, thereby allowing control of the dissolved nitrogen concentration and the supply amount of the ultrapure water introduced into cleaning bath 20.

Solution introduction pipe 23 is provided with a plurality of nozzles which are not shown. Ultrapure water used as a cleaning solution is supplied from solution introduction pipe 23 through these nozzles into cleaning bath 20. The plurality of nozzles is disposed spaced apart from each other in the direction in which solution introduction pipe 23 extends. Furthermore, these nozzles are disposed so as to eject the cleaning solution toward the region located nearly in the center of cleaning bath 20 (the region in which a wafer W to be cleaned is held).

Cleaning bath 20 is provided therein with a holding unit 22 for holding wafer W. An example of wafer W may include a semiconductor wafer. In the state where wafer W is held by holding unit 22 within cleaning bath 20, the cleaning solution containing the above-described mixed ultrapure water is supplied from solution introduction pipe 23 into cleaning bath 20.

As described above, solution introduction pipe 23 is disposed in the lower portion of cleaning bath 20 (the region located in the vicinity of the bottom wall or located in the outer circumference of the bottom wall that is an interface between the bottom wall and the sidewall). From solution introduction pipe 23, a prescribed amount of cleaning solution (mixed ultrapure water) is supplied into cleaning bath 20. Cleaning bath 20 is filled with the cleaning solution. In addition, the supply amount of the cleaning solution is adjusted such that there is an overflow of a prescribed amount of cleaning solution from the upper portion of cleaning bath 20. This causes wafer W to be dipped in the cleaning solution within cleaning bath 20 as shown in Fig. 1.

Coupling bath 21 has a supply line (not shown) connected thereto for supplying a medium that is different from that supplied by the above-described supply means 10. For example, water as a medium is supplied from the supply line into coupling bath 21. Then, the water stored in coupling bath 21 is in contact with at least the bottom wall of the above-described cleaning bath 20. It is to be noted that there is also an overflow of a certain amount of water from coupling bath 21 by continuously supplying a prescribed amount of water from the supply line also to coupling bath 21.

Irradiation means 30 is installed in such a manner that it is connected to the bottom wall of coupling bath 21. Irradiation means 30 irradiates ultrasonic waves to the water within coupling bath 21. The irradiated ultrasonic waves are also irradiated through the water within coupling bath 21 and the portion in contact with this water within cleaning bath 20 (for example, the bottom wall) to the cleaning solution and wafer W within cleaning bath 20.

In this case, irradiation means 30 can oscillate the ultrasonic waves, for example, having a frequency of not less than 20 kHz and not more than 2 MHz, and having a watt density of not less than 0.05 W/cm² and not more than 7.0 W/cm². The ultrasonic waves are irradiated to the cleaning solution and wafer W in this way, which allows efficient cleaning of wafer W dipped in the cleaning solution. In addition, the ultrasonic waves irradiated from irradiation means 30 may preferably show a frequency falling within a range between not less than 400 kHz and not more than 1 MHz.

Monitoring means 40 includes an extraction pipe 41 for extracting a prescribed amount of cleaning solution from inside of cleaning bath 20, a pump 42 connected to extraction pipe 41 for introducing the cleaning solution into a dissolved nitrogen concentration meter 43, and this dissolved nitrogen concentration meter 43 connected to the downstream of pump 42. Dissolved nitrogen concentration meter 43 outputs the measurement data of the dissolved nitrogen concentration in the cleaning solution to a control device, an external display device and the like of the ultrasonic cleaning apparatus. Although a device having an arbitrary configuration can be used as dissolved nitrogen concentration meter 43, a measuring device may be used, for example, that introduces the dissolved gas component contained in the cleaning solution through a polymer membrane into a receptor to calculate the concentration of this gas component based on a change in the thermal conductivity within this receptor.

Cleaning bath 20 is, for example, made of silica glass having a thickness of 3.0 mm. Although cleaning bath 20 can be formed in an arbitrary shape, for example, a rectangular-shaped bath having inside dimensions including a width of 270 mm x a depth of 69 mm x a height of 270 mm is used. Cleaning bath 20 has a capacity of 5 liters.

In addition, it is preferable that the thickness of the plate member made of silica glass forming the bottom wall of cleaning bath 20 is adjusted as appropriate in accordance with the frequency of the ultrasonic waves emitted from irradiation means 30. For example, it is preferable that the plate member forming the bottom wall has a thickness of 3.0 mm in the case where the frequency of the ultrasonic waves emitted from irradiation means 30 is 950 kHz. Furthermore, it is also preferable that the plate member forming the bottom wall has a thickness, for example, of 4.0 mm in the case where the frequency of the ultrasonic waves emitted from irradiation means 30 is 750 kHz.

The amount of the cleaning solution (mixed ultrapure water) supplied from supply means 10 to cleaning bath 20 may be 5 liters per minute. Furthermore, the frequency of the ultrasonic waves emitted from irradiation means 30 may be 950 kHz and 750 kHz as described above while the output thereof may be 1200 W (watt density of 5.6 W/cm²). Furthermore, the radiation plane of the diaphragm in irradiation means 30 may have a size of 80 mm x 270 mm.

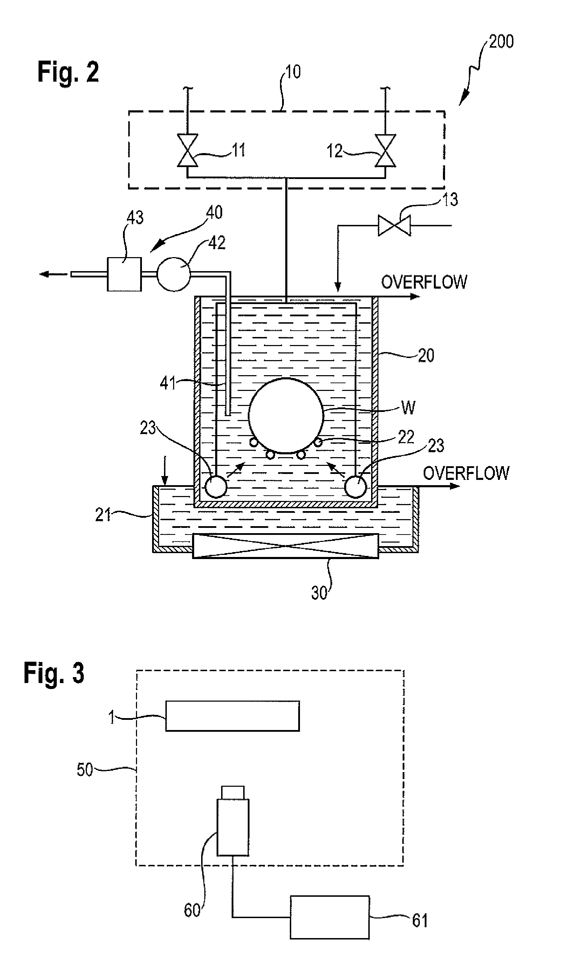

Referring to Fig. 3, the device configuration for observing sonoluminescence (luminescence phenomenon) will be hereinafter described. First, an ultrasonic cleaning apparatus 1 and a luminescence detection device 60 are disposed within a dark room 50. Luminescence detection device 60 is connected to an image processing device 61. The image intensifier unit (extremely weak light sensing intensifier unit) used herein as luminescence detection device 60 serves to sense and intensify the extremely weak light to obtain an image having contrasts. Specifically, a unit employing an image intensifier (V4435U-03) manufactured by Hamamatsu Photonics can be used as the above-described unit. This unit is configured such that the photoelectric surface is made of Cs-Te, the sensitivity wavelength falls within a range of 160 to 320 nm, and the maximum sensitivity occurs at a wavelength of 250 nm. In addition, it is considered that luminescence at the time when ultrasonic waves are irradiated to water is caused by a hydroxy radical (OH radical) generated by water decomposition, and the wavelength of the luminescence is assumed to fall within an ultraviolet region in the vicinity of 309 nm. Therefore, the image intensifier unit composed of a photoelectric surface (Cs-Te) having a wavelength falling within the above-described sensitivity wavelength range is used in this case. In addition, a photomultiplier tube may be used as luminescence detection device 60. It is to be noted that examples of the conditions for the device may include ultrasonic frequency, ultrasonic intensity, bath design allowing the solution to be held, supply amount of the solution, and the like.

Then, the ultrasonic cleaning method according to the present embodiment will be hereinafter described.

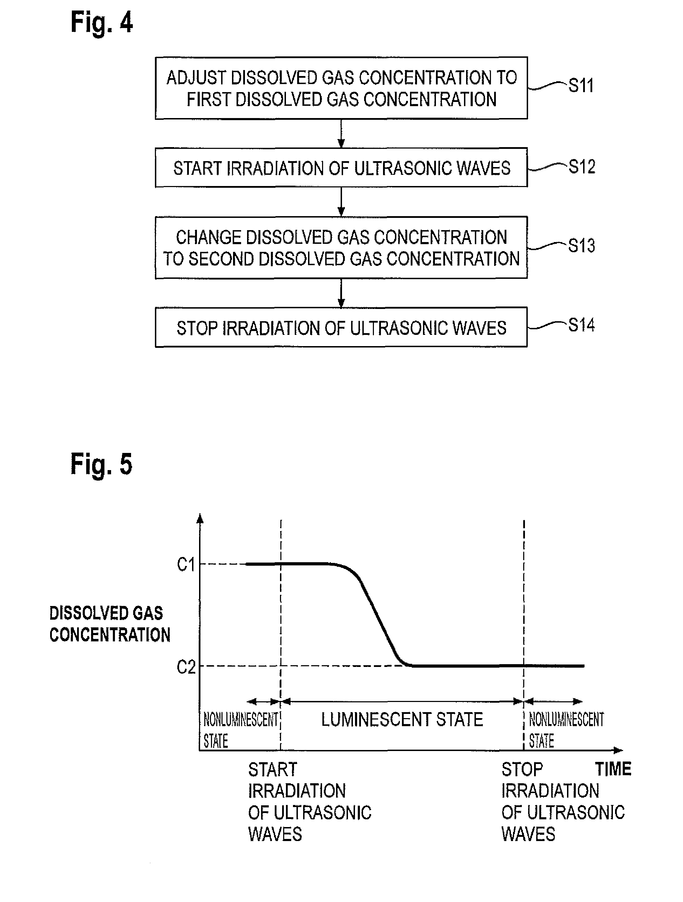

Referring to Figs. 4 and 5, the ultrasonic cleaning method according to the present embodiment will be described. The ultrasonic cleaning method according to the present embodiment is to irradiate ultrasonic waves to the solution having gas such as nitrogen dissolved therein, thereby cleaning wafer W (an object to be cleaned) dipped in the solution. The method mainly includes the following steps.

First, the step (S11) of adjusting the dissolved gas concentration to the first dissolved gas concentration is carried out. For example, the cleaning apparatus shown in Fig. 1 is used to mix the ultrapure water having nitrogen gas dissolved therein and the degassed ultrapure water to prepare a solution having the first dissolved gas concentration. The dissolved gas concentration of the solution at this point of time is the first dissolved gas concentration (C1). At this point of time, ultrasonic waves are not irradiated to the solution and sonoluminescence does not occur.

Then, the step (S12) of starting to irradiate ultrasonic waves is carried out. The dissolved gas concentration of the solution at the time when irradiation of ultrasonic waves is started is the first dissolved gas concentration. Ultrasonic waves are irradiated to the solution by irradiation means 30 for emitting ultrasonic waves as shown in Fig. 1. When ultrasonic waves are irradiated, sonoluminescence occurs. Sonoluminescence can be detected by an image intensifier and a photomultiplier tube as shown in Fig. 3.

Then, the step (S13) of changing the dissolved gas concentration from the first dissolved gas concentration (C1) to the second dissolved gas concentration (C2) is carried out. The dissolved gas concentration can be changed, for example, by adjusting first supply valve 11 of ultrasonic cleaning apparatus 100 shown in Fig. 1 to thereby decrease the supply amount of the ultrapure water having nitrogen gas dissolved therein. The dissolved gas concentration can also be changed by adjusting second supply valve 12 of ultrasonic cleaning apparatus 100 to thereby increase the supply amount of the ultrapure water having no nitrogen gas dissolved therein. Furthermore, the dissolved gas concentration of the solution can also be adjusted by adjusting both of first supply valve 11 and second supply valve 12. Ultrasonic waves are continuously irradiated to the solution while the dissolved gas concentration in the solution is changed from the first dissolved gas concentration (C1) to the second dissolved gas concentration (C2). Also, sonoluminescence occurring state continues while ultrasonic waves are irradiated to the solution. After the dissolved gas concentration of the solution is changed to the second dissolved gas concentration, wafer W that is an object to be cleaned is disposed within the solution. Irradiation of ultrasonic waves is continued for a while until cleaning of wafer W is completed.

Then, the step (S14) of stopping irradiation of ultrasonic waves is carried out. Then, cleaning of wafer W is ended. Wafer W may be removed before irradiation of ultrasonic waves is stopped. When irradiation of ultrasonic waves is stopped, occurrence of sonoluminescence is also stopped.

The method of determining the first dissolved gas concentration (C1) and the second dissolved gas concentration (C2) will be hereinafter described. For example, the cleaning solutions having different dissolved gas concentrations are prepared, in which wafer W to be cleaned is dipped. Then, ultrasonic waves are irradiated to the cleaning solution for cleaning wafer W under the same conditions except for the dissolved gas concentration of the cleaning solution. In this instance, in the case of the dissolved gas concentration at which sonoluminescence does not occur only by simply starting irradiation of ultrasonic waves, it is necessary to cause sonoluminescence to occur by the method according to the present invention. Consequently, assuming that the dissolved gas concentration of the cleaning solution having the highest cleaning efficiency is the optimum dissolved gas concentration, this concentration is determined as the second dissolved gas concentration. Since wafer W is cleaned eventually in the solution having the second dissolved gas concentration, it is preferable that the second dissolved gas concentration is close to the optimum dissolved gas concentration. However, the second dissolved gas concentration does not need to be the optimum dissolved gas concentration as long as it allows occurrence of sonoluminescence. The first dissolved gas concentration is determined as a concentration higher than the second dissolved gas concentration.

Then, the operations and effects of the present embodiment will be described.

In the cleaning method according to the present embodiment, after starting irradiation of ultrasonic waves in the high dissolved gas concentration at first, the dissolved gas concentration is lowered in the state where irradiation of ultrasonic waves is continued. This allows achievement of a particle removal efficiency higher than that in the case where cleaning is performed in a constant dissolved gas concentration. Furthermore, since the method according to the present embodiment allows occurrence of the sonoluminescence state in a wide dissolved gas concentration range, a high particle removal efficiency is achieved with stability.

### Second Embodiment

Referring to Fig. 2, an explanation will be made with regard to an ultrasonic cleaning apparatus 200 to which the ultrasonic cleaning method according to the present second embodiment is applied. Although ultrasonic cleaning apparatus 200 is different from ultrasonic cleaning apparatus 100 in that it has a third supply valve 13 for supplying the solution having a high dissolved gas concentration, it is almost identical to ultrasonic cleaning apparatus 100 except this difference.

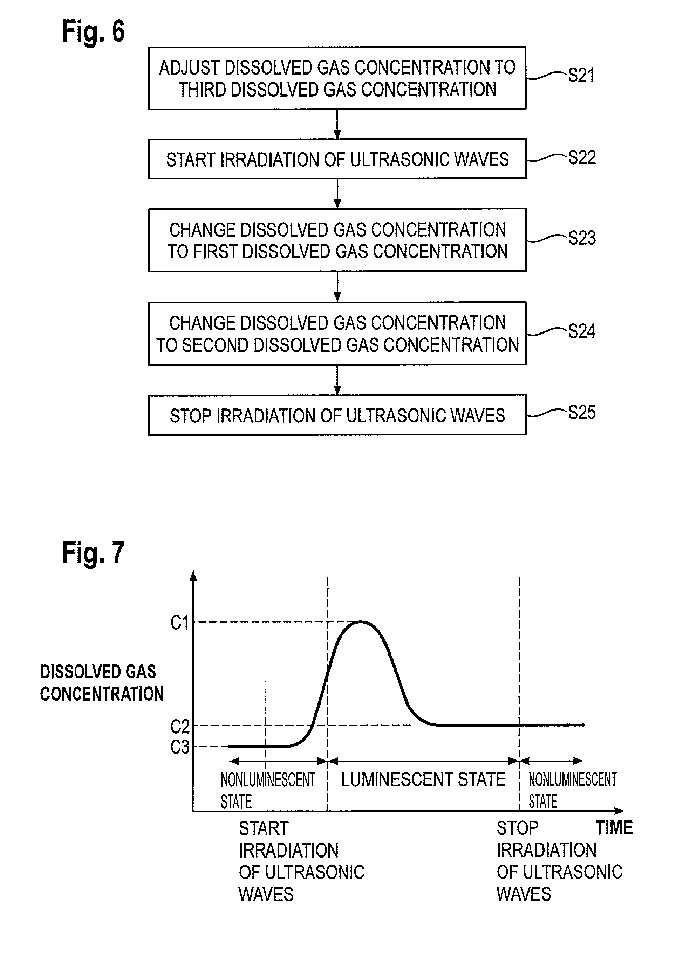

Then, the ultrasonic cleaning method according to the present second embodiment will be hereinafter described with reference to Figs. 6 and 7.

First, the step (S21) of adjusting the dissolved gas concentration to the third dissolved gas concentration is carried out. For example, the cleaning apparatus shown in Fig. 2 is used to mix the ultrapure water having nitrogen gas dissolved therein and the degassed ultrapure water to prepare the solution having the third dissolved gas concentration. The dissolved gas concentration of the solution at this point of time is the third dissolved gas concentration (C3). At this point of time, ultrasonic waves are not irradiated to the solution and sonoluminescence does not occur. The third dissolved gas concentration is lower than the above-described first dissolved gas concentration. The third dissolved gas concentration may be approximately the same as the above-described second dissolved gas concentration. Furthermore, the third dissolved gas concentration may be higher or lower than the second dissolved gas concentration.

Then, the step (S22) of starting to irradiate ultrasonic waves is carried out. The dissolved gas concentration of the solution at the time when irradiation of ultrasonic waves is started is the third dissolved gas concentration. For example, by irradiation means 30 for emitting ultrasonic waves shown in Fig. 2, ultrasonic waves are irradiated to the solution in which wafer W is dipped. In contrast to the first embodiment, sonoluminescence does not always occur at this stage, even when ultrasonic waves are irradiated. In the present second embodiment, sonoluminescence does not occur at the time when irradiation of ultrasonic waves is started.

Then, the step (S23) of changing the dissolved gas concentration from the third dissolved gas concentration (C3) to the first dissolved gas concentration (C1) is carried out. The dissolved gas concentration is changed, for example, by adjusting third supply valve 13 of the cleaning apparatus shown in Fig. 2 to thereby supply the solution having a high dissolved gas concentration to cleaning bath 20 housing wafer W. Ultrasonic waves are continuously irradiated to the solution while the dissolved gas concentration in the solution is changed from the third dissolved gas concentration (C3) to the first dissolved gas concentration (C1). At the time when the dissolved gas concentration of the solution is the third dissolved gas concentration (C3), sonoluminescence does not occur which is regarded as a nonluminescent state. In the middle of changing the dissolved gas concentration from the third dissolved gas concentration (C3) to the first dissolved gas concentration (C1), however, sonoluminescence occurs to bring about a luminescent state.

Then, the step (S24) of changing the dissolved gas concentration from the first dissolved gas concentration (C1) to the second dissolved gas concentration (C2) is carried out. A preparation can be made to change the dissolved gas concentration by adjusting first supply valve 11 and second supply valve 12 of ultrasonic cleaning apparatus 200 shown in Fig. 2, as in the case described in the first embodiment. Ultrasonic waves are continuously irradiated to the solution while the dissolved gas concentration in the solution is changed from the first dissolved gas concentration (C1) to the second dissolved gas concentration (C2). Furthermore, the sonoluminescence occurring state continues while ultrasonic waves are irradiated to the solution. After the dissolved gas concentration of the solution is changed to the second dissolved gas concentration, wafer W that is an object to be cleaned is placed within the solution. Irradiation of ultrasonic waves is continued for a while until cleaning of the object to be cleaned is completed.

Then, the step (S25) of stopping irradiation of ultrasonic waves is carried out. Consequently, cleaning of wafer W is ended. Wafer W may be removed before irradiation of ultrasonic waves is stopped. When irradiation of ultrasonic waves is stopped, occurrence of sonoluminescence is also stopped.

The operations and effects of the present embodiment is the same as those in the first embodiment.

### Example 1

An object of the present experiment is to verify the difference of the particle removal efficiency adhering to wafer W by cleaning wafer W using the cleaning method according to the present invention and the cleaning method according to the comparative example.

First, the cleaning apparatus used in the present experiment will be hereinafter described with reference to Fig. 1.

A rectangular-shaped bath made of silica glass and having a thickness of 3.0 mm was used as cleaning bath 20 used in this experiment. The bath was configured to have inside dimensions including a width of 270 mm x a depth of 69 mm x a height of 270 mm. The plate member forming the bottom wall is configured to have a thickness of 4.0 mm. Cleaning bath 20 has a capacity of 5 liters.

The amount of the cleaning solution (mixed ultrapure water) supplied from supply means 10 to cleaning bath 20 was set at 5 liters per minute. Furthermore, the ultrasonic waves emitted from irradiation means 30 were set to have a frequency of 750 kHz and an output of 1200W (watt density of 5.6 W/cm²). Furthermore, the radiation plane of the diaphragm in irradiation means 30 was set to have a size of 80 mm x 270 mm. The ultrasonic waves emitted from irradiation means 30 are irradiated to the entire bottom surface of cleaning bath 20.

The ultrapure water having nitrogen dissolved therein was supplied to cleaning bath 20 at 5 liters per minute by operating first supply valve 11 adjusting the supply amount of the ultrapure water having nitrogen gas dissolved therein and second supply valve 12 adjusting the supply amount of the degassed water. The dissolved nitrogen concentration was measured by sampling the ultrapure water within the bath by monitoring means 40.

Then, the object to be cleaned used for measuring the particle removal efficiency will be hereinafter described. A P-type silicon wafer having a diameter of 200 mm was used as an object to be cleaned. Spin coating was employed to cause silicon dioxide particles to adhere to the mirror surface of the P-type silicon wafer. In this case, 2000 to 3000 particles of not less than 110 nm diameter were adhered.

Then, the method of measuring the particle removal efficiency will be hereinafter described.

The wafer having silicon dioxide particles adhered thereonto was dipped in the bath and cleaned for 10 minutes. Then, the wafer was dried for 2 minutes by a spin dryer. The particle removal efficiency is represented by a value in percentages calculated by dividing the number of particles reduced after cleaning by the number of particles adhering to the wafer before cleaning. It is to be noted that LS6500 manufactured by Hitachi High Technologies Corporation was used for measuring the amount of adhered particles.

### Example 1 according to the Present Invention

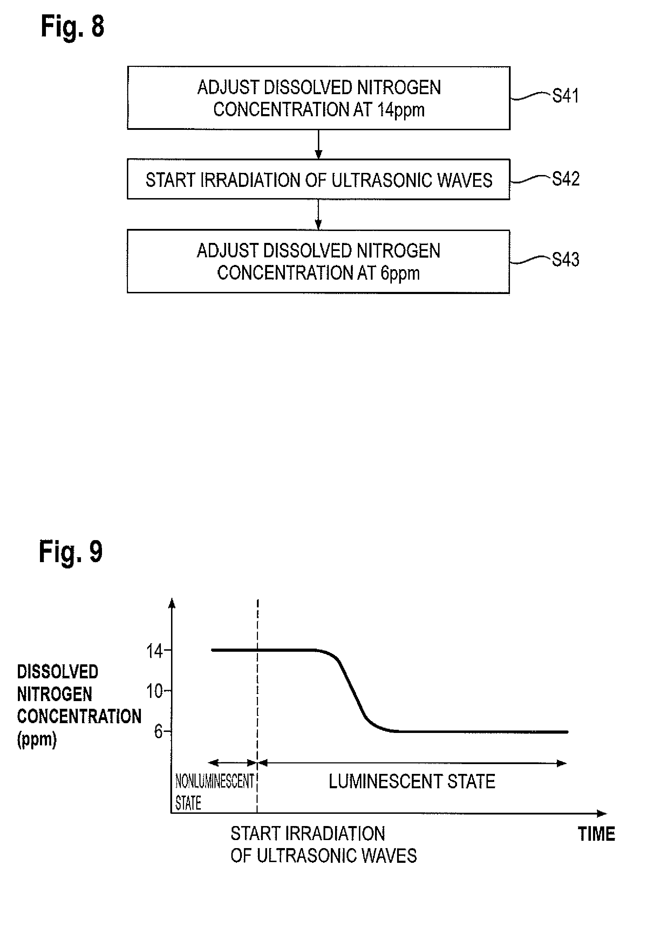

Referring to Figs. 8 and 9, the cleaning method according to Example 1 of the present invention will be hereinafter described.

First, the solution having the dissolved nitrogen concentration adjusted at 14 ppm was prepared (S41). No sonoluminescence was observed in the stage before ultrasonic waves were irradiated to the solution (nonluminescent state). Then, irradiation of ultrasonic waves was started in the state where the dissolved nitrogen concentration was 14 ppm (S42). When irradiation of ultrasonic waves was started, sonoluminescence occurs (luminescent state). Occurrence of sonoluminescence was confirmed by an image intensifier unit. Then, the dissolved nitrogen concentration of the solution was adjusted from 14 ppm to 6 ppm (S43). The dissolved nitrogen concentration was adjusted by operating first supply valve 11 adjusting the supply amount of the ultrapure water having nitrogen gas dissolved therein and second supply valve 12 adjusting the supply amount of the degassed water which are included in ultrasonic cleaning apparatus 100 shown in Fig. 1, to thereby supply the ultrapure water having a dissolved nitrogen concentration of 6 ppm to cleaning bath 20 at 5 liters per minute. Ultrasonic waves were continuously irradiated to the solution while the dissolved nitrogen concentration was gradually changed from 14 ppm to 6 ppm. Sonoluminescence continuously occurred while the ultrasonic waves were irradiated. In this state, wafer W to which silicon dioxide particles to be cleaned were adhered was dipped in this solution and cleaned for 10 minutes. Then, wafer W was dried for 2 minutes by the spin dryer.

### Example 2 according to the Present Invention

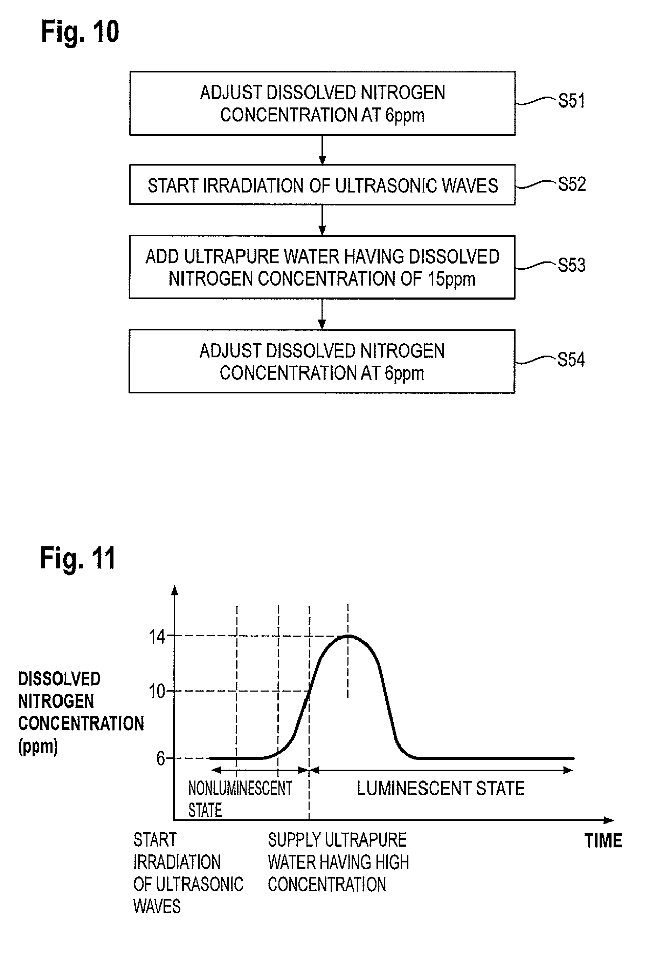

Referring to Figs. 10 and 11, the cleaning method according to Example 2 of the present invention will be hereinafter described.

First, the solution having the dissolved nitrogen concentration adjusted at 6 ppm was prepared (S51). The dissolved nitrogen concentration was adjusted by operating first supply valve 11 adjusting the supply amount of the ultrapure water having nitrogen gas dissolved therein and second supply valve 12 adjusting the supply amount of the degassed water which were included in ultrasonic cleaning apparatus 200 shown in Fig. 2, to thereby supply the ultrapure water having a dissolved nitrogen concentration of 6 ppm to cleaning bath 20 at 5 liters per minute. Then, irradiation of ultrasonic waves was started in the state where the dissolved nitrogen concentration was 6 ppm (S52). No sonoluminescence was observed at the time when irradiation of ultrasonic waves was started. Then, the ultrapure water having a dissolved nitrogen concentration of 15 ppm was added to cleaning bath 20 while irradiation of ultrasonic waves was continued (S53). The ultrapure water having a dissolved nitrogen concentration of 15 ppm was supplied to cleaning bath 20 at a flow rate of 5 liters per minute by opening third supply valve 13 connected from the ultrapure water supply line of 15 ppm to the bath. When the ultrapure water within the bath was sampled by monitoring means 40 to measure the dissolved nitrogen concentration, luminescence was started once the dissolved nitrogen concentration exceeded 10 ppm. When the ultrapure water having a dissolved nitrogen concentration of 15 ppm was continuously supplied, the dissolved nitrogen concentration of the solution within cleaning bath 20 reached 14 ppm. Then, the third supply valve was closed to stop supply of ultrapure water of 15 ppm. After a while, the dissolved nitrogen concentration of the solution within cleaning bath 20 reached 6 ppm. The luminescent state continued even when the dissolved nitrogen concentration was returned to 6 ppm. In this state, wafer W to which silicon dioxide particles to be cleaned were adhered was dipped in the solution and cleaned for 10 minutes. Then, wafer W was dried for 2 minutes by the spin dryer.

### Comparative Example

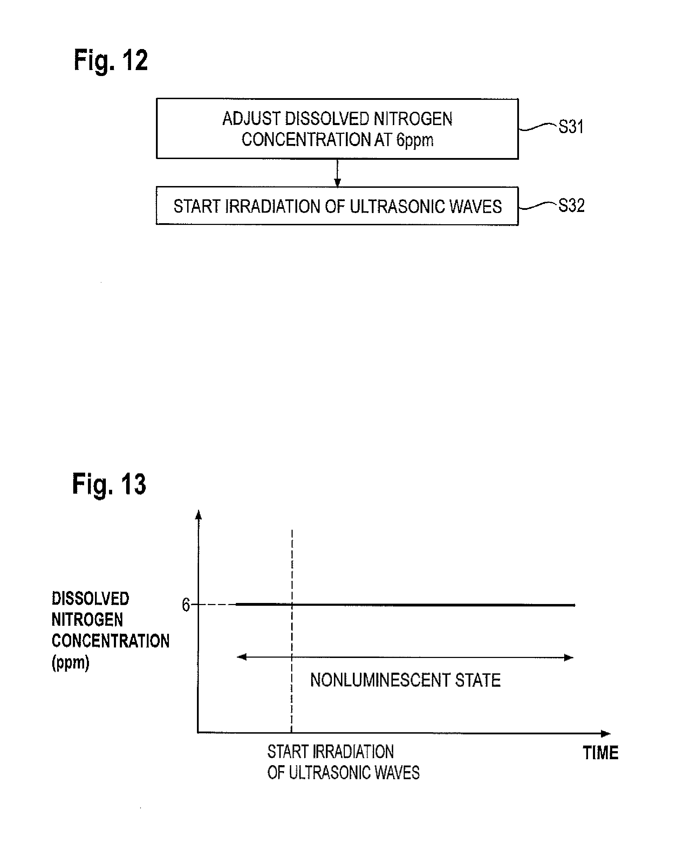

The cleaning method according to the comparative example will be hereinafter described with reference to Figs. 12 and 13.

First, the solution having a dissolved nitrogen concentration adjusted at 6 ppm was prepared (S31). The dissolved nitrogen concentration was adjusted by operating first supply valve 11 adjusting the supply amount of ultrapure water having nitrogen gas dissolved therein and second supply valve 12 adjusting the supply amount of the degassed water, to thereby supply the ultrapure water having a dissolved nitrogen concentration of 6 ppm to cleaning bath 20 at 5 liters per minute. Then, irradiation of ultrasonic waves was started (S32). Irradiation of ultrasonic waves was carried out by emitting ultrasonic waves under the condition in which the dissolved nitrogen concentration was 6 ppm and under the same conditions as those in Examples 1 and 2 of the present invention. When an image intensifier unit was used to make observations in the state where ultrasonic waves were irradiated, it was confirmed that a nonluminescent state was brought about. In this state, wafer W to which silicon dioxide particles to be cleaned were adhered was dipped in the solution and cleaned for 10 minutes. Then, wafer W was dried for 2 minutes by the spin dryer.

Then, the results of the particle removal efficiency will be hereinafter described with reference to Table 1.

**Table 1**

| | Particle Removal Efficiency | Occurrence or Nonoccurrence of Luminescence |
|---|---|---|
| Example 1 of the Present Invention | 30.5 % | Luminescence occurred |
| Example 2 of the Present Invention | 30.6 % | Luminescence occurred |
| Comparative Example | 18.8 % | Luminescence not occurred |

As shown in Table 1, the particle removal efficiency achieved by the cleaning method according to the comparative example was 18.8 %. On the other hand, the particle removal efficiency achieved by the cleaning method according to Example 1 of the present invention was 30.5 %. Furthermore, the particle removal efficiency achieved by the cleaning method according to Example 2 of the present invention was 30.6 %. The particle removal efficiency in each of Examples 1 and 2 of the present invention was higher than the particle removal efficiency in the comparative example. Furthermore, luminescence (sonoluminescence) was observed in Examples 1 and 2 of the present invention while luminescence (sonoluminescence) was not observed in the comparative example.

This experiment showed that the cleaning method according to the present invention could improve the particle removal efficiency. It was also confirmed that luminescence (sonoluminescence) was observed when the particle removal efficiency was high while luminescence (sonoluminescence) was not observed when the particle removal efficiency was low.

### Example 2

An object of the present experiment is to examine the relationship between the luminescence (sonoluminescence) state and the final dissolved nitrogen concentration at the time when the dissolved nitrogen concentration in the solution was adjusted using each of the cleaning method according to the present invention and the cleaning method according to the comparative example.

In the example of the present invention, the solution having a dissolved nitrogen concentration of 15 ppm was first prepared. Irradiation of ultrasonic waves to this solution was started. The ultrasonic waves have a frequency of 750 kHz and an output of 1200 W. In this state, an observation was made by an image intensifier unit as to whether luminescence occurred or not. Then, while lowering the dissolved nitrogen concentration from 15 ppm for each 1 ppm, it was observed whether luminescence occurred or not under each dissolved nitrogen concentration condition.

In the comparative example, the solutions having dissolved nitrogen concentrations of 0 ppm to 15 ppm were prepared. The dissolved nitrogen concentration was adjusted for each 1 ppm from 0 ppm to 15 ppm, to prepare a total of 16 types of solutions. Then, irradiation of ultrasonic waves was started for each solution. The conditions of the ultrasonic waves are the same as those in the example of the present invention. While irradiating ultrasonic waves to each solution, it was observed by the image intensifier unit whether luminescence occurred or not.

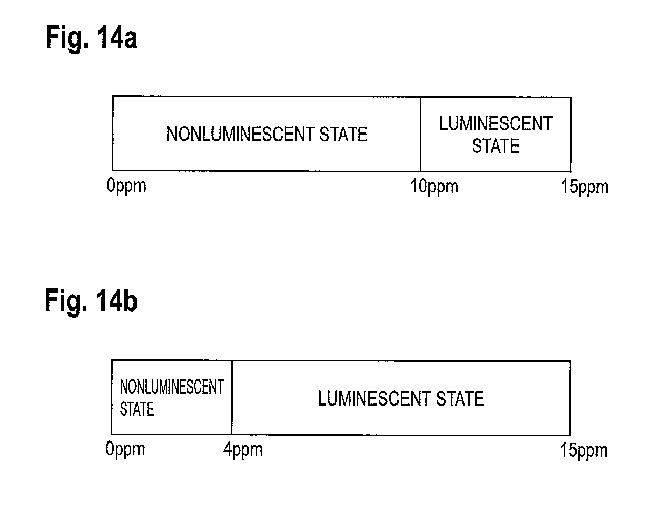

The results of the present experiment will be described with reference to Fig. 14. Fig. 14 (a) shows the result of the comparative example and Fig. 14 (b) shows the result of the example of the present invention. As shown in Fig. 14 (a), when the solution directly adjusted to the target dissolved nitrogen concentration was used, the luminescent state was observed in the dissolved nitrogen concentration in the range between not less than 10 ppm and not more than 15 ppm. On the other hand, as shown in Fig. 14 (b), when using the solution that was first adjusted at a high dissolved nitrogen concentration which was then lowered and adjusted to the target dissolved nitrogen concentration, a luminescent state was observed in the dissolved nitrogen concentration in the range between not less than 4 ppm and not more than 15 ppm. In other words, it was confirmed that the luminescent state of the solution was changed by the method of adjusting the dissolved nitrogen concentration even when the final dissolved nitrogen concentrations were the same. Furthermore, as confirmed in Example 1, the particle removal efficiency at the time when wafer W is cleaned in the luminescent state is higher than that at the time when wafer W is cleaned in the nonluminescent state. In other words, the cleaning method according to the example of the present invention can achieve a higher particle removal efficiency in a wide dissolved nitrogen concentration range than that in the case of the cleaning method according to the comparative example.

It should be understood that the embodiments and examples disclosed herein are illustrative and non-restrictive in every respect. The scope of the present invention is defined by the terms of the claims, rather than the embodiments and examples described above, and is intended to include any modifications within the scope and meaning equivalent to the terms of the claims.

## Claims

1. An ultrasonic cleaning method for irradiating ultrasonic waves to a solution having gas dissolved therein for cleaning an object to be cleaned in said solution, said method comprising the steps of:
- irradiating ultrasonic waves to said solution having a first dissolved gas concentration; and
- changing a dissolved gas concentration in said solution from said first dissolved gas concentration to a second dissolved gas concentration lower than said first dissolved gas concentration, in a state where ultrasonic waves are being irradiated to said solution,
sonoluminescence occurring by irradiating ultrasonic waves to said solution while said dissolved gas concentration in said solution is changed from said first dissolved gas concentration to said second dissolved gas concentration.

2. The ultrasonic cleaning method according to claim 1, wherein irradiation of ultrasonic waves is started at a point of time when said dissolved gas concentration reaches said first dissolved gas concentration.

3. The ultrasonic cleaning method according to claim 1, further comprising the steps of:
- starting to irradiate ultrasonic waves to said solution having a third dissolved gas concentration lower than said first dissolved gas concentration; and
- changing said dissolved gas concentration in said solution from said third dissolved gas concentration to said first dissolved gas concentration in a state where ultrasonic waves are being irradiated to said solution.

4. The ultrasonic cleaning method according to claim 3, wherein the step of changing said dissolved gas concentration from said third dissolved gas concentration to said first dissolved gas concentration is performed by adding a solution having said dissolved gas concentration higher than said third dissolved gas concentration to a cleaning bath housing said object to be cleaned.

5. The ultrasonic cleaning method according to any one of claims 1 to 4, wherein said gas is nitrogen and said second dissolved gas concentration is not less than 4 ppm and not more than 10 ppm.
